# EUROPÄISCHE PATENTSCHRIFT

(11) **EP 4 197 298 B1**
(45) Veröffentlichungstag und Bekanntmachung des Hinweises auf die Patenterteilung: **02.10.2024**
(21) Anmeldenummer: 21758669.2
(22) Anmeldetag: 10.08.2021
(51) Int. Cl.: H05K 5/02, H02G 3/10, F16B 5/06, F16B 5/02

(54) **VORRICHTUNG ZUR MONTAGE EINES GEHÄUSES**
DEVICE FOR MOUNTING A HOUSING
DISPOSITIF DE MONTAGE D'UN BOÎTIER

(30) Priorität: 12.08.2020 DE 202020104684 U
(43) Veröffentlichungstag der Anmeldung: 21.06.2023
(73) Patentinhaber: Georg Schlegel GmbH & Co. KG, 88525 Duermentingen (DE)
(72) Erfinder: SCHLEGEL, Christoph, 88400 Biberach (DE); BLANK, Kurt, 88422 Bad Buchau (DE); KAESTLE, Andreas, 88356 Ostrach/Einhart (DE)
(74) Vertreter: Otten, Roth, Dobler & Partner mbB Patentanwälte
(86) Internationale Anmeldenummer: PCT/EP2021/072257
(87) Internationale Veröffentlichungsnummer: WO 2022/034066

(56) Entgegenhaltungen:
- EP-A1- 1 408 272
- GB-A- 2 250 054
- JP-U- S6 377 383
- US-A- 4 660 793
- US-A- 5 220 712
- US-A1- 2008 105 803
- US-A1- 2010 176 261
- US-A1- 2019 059 169

## Beschreibung

### Stand der Technik

Funktionselemente insbesondere Gehäuse, die dazu ausgelegt sind, elektrische und/oder elektronische Bauteile aufzunehmen, sind allgemein bekannt. Dabei umfassen bekannte Funktionselemente eine Durchführung für eine Strom- bzw. Spannungsversorgung der elektrischen oder elektronischen Bauteile. In der US 2010/0176261 A1 ist eine Wandaufhängung für eine Computervorrichtung offenbart. Dabei umfasst die Wandaufhängung zwei Komponenten, welche lösbar miteinander verbunden werden können, wobei eine Komponente an einer Wand und eine weitere Komponente mit der Computervorrichtung verbindbar sind. Auch in der JP S6377383 U wird eine Wandaufhängung für ein Gehäuse offenbart, wobei das Gehäuse Verrastungselemente aufweist, welche lösbar mit einer an einer Wand anbringbaren Verbindungsvorrichtung verrastet werden können.

Es ist bekannt, dass Funktionselemente direkt an einer Oberfläche mit Hilfe von Befestigungsmittel, z.B. Schrauben, montiert werden können. Nachteilig ist dabei, dass für jede Überprüfung und/oder Reparatur der elektrischen oder elektronischen Bauteile, die im Funktionselement aufgenommen sind, das Funktionselement von der Oberfläche, vergleichsweise aufwendig demontiert werden muss.

### Aufgabe und Vorteile der Erfindung

Der Erfindung liegt die Aufgabe zu Grunde eine Montage eines Funktionselements an eine Oberfläche wirtschaftlich und technisch zu verbessern.

Die Aufgabe wird durch die Merkmale der unabhängigen Ansprüche gelöst.

Vorteilhafte und zweckmäßige Ausführungsformen, Varianten und Weiterbildungen der Erfindung sind in den abhängigen Ansprüchen ausgeführt.

Die Erfindung geht aus von einem System aus einem Funktionselement, insbesondere Gehäuse, und einer Vorrichtung zur Montage des Funktionselements, wobei die Vorrichtung Mittel zur Befestigung der Vorrichtung an eine Oberfläche aufweist. Das Funktionselement besitzt vorzugsweise eine Durchführung für eine Strom- bzw. Spannungsversorgung eines elektrischen und/oder eines elektronischen Bauteils. Das Funktionselement besitzt einen Innenraum zum Einsetzen von elektronischen und/oder elektrischen Bauteilen.

Das System umfasst bevorzugterweise mehrere voneinander trennbare Systemkomponenten. Dabei ist die erste Systemkomponente vorzugsweise das Funktionselement und die zweite Systemkomponente die Vorrichtung zur Montage des Funktionselements. Die Vorrichtung zur Montage des Funktionselements wird im Folgenden nur noch Vorrichtung genannt.

Das Funktionselement ist vorzugsweise ein Gehäuse, insbesondere ein Gehäuse für elektronische Bauteile. Von Vorteil ist, wenn das Funktionselement sechs Wandabschnitte aufweist, wobei die 6 Wandabschnitte einen Innenraum begrenzen. Im Innenraum des Funktionselements sind bevorzugterweise elektrische und elektronische Bauteile aufnehmbar. An einer Oberseite des Funktionselements befindet sich im montierten Zustand vorzugsweise eine Vertiefung, Bohrung, Durchbruch oder mehrere Vertiefungen, bzw. Bohrungen, Durchbrüche in denen ein Bedienungselement, z.B. ein Druckknopf und/oder ein Schalter und/oder eine Taste, beispielsweise eine Not-Halt Taste, angeordnet ist. Alternativ kann die Oberseite des Funktionselements auch keine Vertiefungen aufweisen. Weiter können im Innenraum des Funktionselements unterschiedliche elektronische und/oder elektrische Bauteile, wie z.B. Kabel, Leiterplatten, Klemmen, Reihenklemmen, Transmitter und/oder Antennen angeordnet sein. Vorteilhafterweise ergibt das Funktionselement mit den elektronischen und/oder elektronischen Bauteilen ein Gerät mit z.B. einen Schalter oder mehreren Schalteinrichtungen. Vorteilhafterweise ist an einem Wandabschnitt des Funktionselements eine Durchführung ausgebildet, in welcher beispielsweise ein isoliertes Stromkabel mit einer oder mehreren elektrischen Leitungen, anordbar ist. Über die Stromkabel können vorteilhafterweise die elektrischen oder elektronischen Bauteile, die innerhalb des Funktionselements untergebracht sind, elektrisch angebunden werden. Eine weitere Möglichkeit ist, dass das Funktionselement eine Öffnung für eine Steckverbindung aufweist, wobei ein Kabel einen Stecker aufweist, wobei das Kabel mit einer Energiequelle verbunden ist, und der Stecker des Kabels in die Öffnung am Funktionselement eingesteckt werden kann. Das Funktionselement kann auch eine Antenne aufweisen. Das Funktionselement umfasst vorzugsweise isolierendes Material, z.B. ein Polymer, oder metallisches Material, z.B. Edelstahl.

Vorteilhafterweise ist das Funktionselement einstückig oder mehrstückig ausgebildet, wobei bei einem mehrstückigen Funktionselement die Teile lösbar miteinander verbindbar sind.

Die Vorrichtung ist bevorzugterweise in einem Nutzzustand zwischen dem Funktionselement und einer statisch belastbaren Oberfläche angeordnet. Bei der Oberfläche handelt es sich, z.B. um eine Wand, einem Aluminium-Profil oder sonstige ebene statisch belastbare Oberflächen.

Bevorzugterweise ist die Vorrichtung plattenartig ausgebildet und weist vorzugsweise eine Materialausnehmung auf. Die Materialausnehmung ist so ausgebildet, dass Mittel zur Befestigung, z.B. Schrauben, aufgenommen werden können, um die Vorrichtung an eine Oberfläche zu Befestigen.

Die Vorrichtung und das Funktionselement sind dazu ausgelegt, ineinandergeschoben zu werden, um eine mechanische Fixierung des Funktionselements an der Vorrichtung, bei an einer Oberfläche montierter Vorrichtung, zu erhalten und dass eine Schnappsicherung vorgesehen ist, um ein Auseinanderschieben der ineinandergeschobenen Systembauteile zu blockieren, wobei die Schnappsicherung beim ineinandergeschobenen und fixierten Zustand der Vorrichtung mit dem Funktionselement von außen, bei an einer Oberfläche montierten Vorrichtung, zugänglich ist und lösbar ist, wobei die Schnappsicherung eine mehrfache Montage und Demontage des Funktionselements an bzw. von der Vorrichtung erlaubt und/oder unterstützt.

Vorzugsweise wird die Vorrichtung zuerst an einer Oberfläche montiert, bevor das Funktionselement an der Vorrichtung montiert bzw. in diese eingeschoben wird. Das Funktionselement kann in die Vorrichtung bis zum Erreichen eines Endmontagezustands eingeschoben werden.

Beim Ineinanderschieben des Funktionselements und der Vorrichtung bis zum Endmontagezustand verrastet die Schnappsicherung. Damit ist vorzugsweise das Funktionselement an der Vorrichtung mechanisch fest fixiert. Ist die Schnappsicherung noch nicht verrastet, kann ohne Hilfsmittel bzw. Werkzeug das Funktionselement aus der Vorrichtung entfernt werden. Ist aber das Funktionselement mit der Vorrichtung verrastet, kann die Verrastung bzw. Fixierung vorzugsweise mit einem Werkzeug, z.B. einem Schraubendreher, von außen gelöst werden. Damit kann das Funktionselement von der Vorrichtung demontiert werden. Nach der Demontage des Funktionselements aus der Vorrichtung, kann vorteilhafterweise das Funktionselement jederzeit wieder werkzeuglos in der Vorrichtung montiert werden. Die Montage bzw. das Einschieben und die Demontage bzw. das Zurückschieben des Funktionselements an der Vorrichtung kann bevorzugterweise beliebig oft wiederholt werden.

Von Vorteil ist, wenn die Vorrichtung eine Lasche umfasst, welche beweglich, vorzugsweise elastisch beweglich z.B. federnd, an dem verbleibenden Teil der Vorrichtung angeordnet ist.

Die Lasche der Schnappsicherung ist insbesondere derart ausgebildet, dass die Lasche relativ zum verbleibenden Teil der Vorrichtung beweglich ist, wobei der verbleibende Teil der Vorrichtung vorzugsweise ein starres Bauteil ist. Dafür weist die Vorrichtung vorzugsweise einen länglichen Einschnitt auf, wobei vorzugsweise zwei längliche Einschnitte vorhanden sind, die gegenüberliegend und parallel verlaufen. Der längliche Einschnitt ist bevorzugterweise zwischen den Außenrändern der Schnappsicherung und einem stegartigen Seitenrand der Vorrichtung ausgebildet.

Ebenfalls von Vorteil ist, dass die Lasche eine Erhebung umfasst, welche so ausgebildet ist, dass die Erhebung mit einer auf die Erhebung angepasste Gegenkontur am Funktionselement verrastbar ist.

Die Lasche umfasst vorzugsweise an einem freien Ende eine Erhebung. Die Lasche mit der Erhebung ist relativ zum verbleibenden Teil der Vorrichtung vorzugsweise elastisch beweglich, so dass die Lasche sich selbst von einem gespannten in einen entspannten Zustand zurückstellt. Vorzugsweise ist die Erhebung an der Seite der Vorrichtung ausgebildet, welche in Kontakt mit dem Funktionselement kommt, beim Ineinanderschieben.

Vorteilhafterweise ist die Erhebung als ein Prisma ausgebildet, welches vorzugsweise eine dreieckige Schnittfläche besitzt. Die Erhebung ist vorzugsweise als Rastnase und/oder als Rastvorsprung ausgebildet. Von Vorteil ist, wenn die Erhebung in eine passende Gegenkontur beispielsweise eine Vertiefung bzw. Einbuchtung am Funktionselement eingreifen kann. Vorteilhafterweise kann die Lasche mit Erhebung aufgrund eines vorgespannten Zugs in die passende Gegenkontur einrasten.

Vorteilhafterweise umfasst das Funktionselement eine Gegenkontur, die auf die Erhebung an der Vorrichtung angepasst ist.

Die Gegenkontur der Schnappsicherung, welche am Funktionselement ausgebildet ist, ist bevorzugterweise auf die Erhebung bzw. die Rastnase der Vorrichtung abgestimmt. Dabei ist die Gegenkontur vorzugsweise eine quaderförmige Vertiefung. Erst durch das Eingreifen der Erhebung der Vorrichtung in die Gegenkontur am Funktionselement ist das Funktionselement mechanisch fest fixiert mit der Vorrichtung. Das Einschnappen der Erhebung in der Gegenkontur erzeugt vorzugsweise ein hörbares Geräusch. Das Geräusch ist vorteilhafterweise von dem Benutzer wahrnehmbar, so dass der Benutzer das Einschnappen oder Einrasten des Funktionselement an der Vorrichtung und somit auch den Endmontagezustand bemerkt. Für die Demontage des Funktionselements von der Vorrichtung ist, vorzugsweise mit Hilfe eines Werkzeuges, die Erhebung aus der Gegenkontur am Funktionselement von außen lösbar.

Es ist auch vorteilhaft, dass die Vorrichtung eine Materialausnehmung aufweist, um Befestigungsmittel aufzunehmen.

Die Materialausnehmung ist z.B. ein Langloch, in welche ein Befestigungsmittel, z.B. eine Schraube, eingreifen kann. Vorteilhafterweise ist zumindest eine Materialausnehmung an der Vorrichtung vorhanden. Bevorzugt sind zwei Materialausnehmungen an der Vorrichtung ausgebildet, die insbesondere als zwei Langlöcher ausgebildet sind. Von Vorteil ist, wenn die Materialausnehmung sich entlang der Breite der Vorrichtung erstreckt. Die Materialausnehmungen sind vorzugsweise trichterartig vertieft. Dabei ist vorteilhafterweise die Materialausnehmung so ausgebildet, dass in Richtung der Rückseite, welche an eine Oberfläche montierbar ist, die Materialausnehmung schmaler wird. Durch die trichterartige bzw. keilartige Vertiefung stehen, im montierten Zustand der Vorrichtung an einer Oberfläche, die Befestigungsmittel an der Vorrichtung nicht über.

Die Vorrichtung umfasst vorzugsweise genau zwei Materialausnehmungen, welche beide vorzugsweise als Langlöcher ausgebildet sind. Damit kann beispielsweise eine Positionierung der Vorrichtung quer zur Horizontalen oder Vertikalen in Bezug auf eine Oberfläche, z.B. eine Wand, erreicht werden.

Erfindungsgemäß weist die Vorrichtung eine Führungsöffnung mit Führungsabschnitten für ein zu den Führungsabschnitten passendes Führungselement mit Führungsvorsprung am Funktionselement auf.

Vorteilhafterweise sind in der Führungsöffnung Führungsstege ausgebildet, wobei die Führungsstege vorzugsweise parallel an der Führungsöffnung angeordnet sind. Beispielsweise umfasst der Führungssteg der Vorrichtung zumindest einen Führungsabschnitt, z.B. gegenüberliegende Führungsabschnitte, die auf den Führungsvorsprung des Führungselements abgestimmt sind. Die Abstimmung kann derart sein, dass die Systembauteile in einer Richtung senkrecht zur Schieberichtung satt bzw. stoffschlüssig zueinander sitzen.

Die Führungsabschnitte an der Vorrichtung hintergreifen vorzugsweise den Führungsvorsprung am Funktionselement beim Ineinanderschieben. Beim Ineinanderschieben der Systembauteile schnappt bevorzugterweise zusätzlich die Schnappsicherung in die Einbuchtung am Funktionselement ein, so dass im Endmontagezustand das Funktionselement mechanisch fest mit der Vorrichtung fixiert ist.

Vorstellbar ist auch, dass der Führungsabschnitt an dem Funktionselement und der Führungsvorsprung an der Vorrichtung ausgebildet ist.

Vorteilhafterweise umfasst die Vorrichtung eine Führungsöffnung, welche einen breiten Bereich und einen schmalen Bereich aufweist, wobei im schmalen Bereich parallel ausgerichtete Führungsstege vorhanden sind.

Von Vorteil ist, wenn die Führungsöffnung rechteckig ausgebildet ist. Bevorzugterweise weist die Vorrichtung zumindest eine Führungsöffnung aus, aber auch zwei oder mehrere Führungsöffnungen sind möglich. Eine Führungsöffnung ist vorzugsweise teilweise in der Lasche ausgebildet. Weiter ist vorteilhaft, wenn die Führungsöffnung sich in Schieberichtung verschmälert, vorzugsweise durch einen Führungssteg oder mehrere Führungsstege. Vorteilhafterweise sind die Führungsstege gegenüberliegend an der Führungsöffnung angeordnet.

Ebenfalls vorteilhaft ist, dass die Führungsöffnung dazu ausgebildet ist, das Führungselement des Funktionselements aufzunehmen.

Von Vorteil ist, wenn das Funktionselement in zwei Schritten in die Vorrichtung, welche an einer Oberfläche montiert ist, eingeschoben werden kann. Zuerst ist vorzugsweise das Führungselement des Funktionselements in einen breiten Bereich der Führungsöffnung der Vorrichtung einsteckbar. Dabei sind an der Vorrichtung stegartige Seitenränder ausgebildet, so dass die Vorrichtung beim Schiebevorgang an länglichen Erhebungen, die in Längsrichtung an der Rückseite des Funktionselements ausgebildet sind, am Funktionselement entlang geschoben werden kann. Die stegartigen Seitenränder und die länglichen Erhebungen sind so ausgebildet, dass beim Endmontagezustand die Seitenränder der Vorrichtung vorzugsweise größtenteils in Kontakt mit den länglichen Erhebungen am Funktionselement kommen. Danach kann im zweiten Schritt das Funktionselement in eine Schieberichtung geschoben werden, so dass das Führungselement in den schmalen Bereich der Führungsöffnung gelangt. Beim Schiebevorgang hintergreift der Führungsvorsprung am Führungselement die Führungsabschnitte am Führungssteg und wird entlang des Führungsabschnitts in einen Endmontagezustand geschoben. In dem schmalen Bereich der Führungsöffnung sind vorzugsweise Führungsstege angeordnet, die eine Bewegung des Funktionselements in alle Richtungen außer in entgegengesetzter Richtung zur Schieberichtung verhindern.

Weiterhin ist vorteilhaft, dass ein Führungselement von einer Rückseite des Funktionselements abstehend ausgebildet ist, wobei die Rückseite des Funktionselements beim Ineinanderschieben der Vorrichtung zugewandt ist.

Vorteilhafterweise ist das Führungselement an einer Rückseite des Funktionselements ausgebildet. Die Rückseite des Funktionselements ist vorzugsweise die Seite, welche im montierten bzw. eingeschobenen Zustand der Vorrichtung zugewandt ist. Das Führungselement ist bevorzugterweise als ein Führungsvorsprung ausgebildet, welches insbesondere zwei gegenüberliegende Schrägen bzw. schräge Flächen aufweist. Vorteilhafterweise unterstützt der Führungsvorsprung das Aufstecken des Funktionselements auf die Vorrichtung. Weiter ist es vorteilhaft wenn der Führungsvorsprung das Funktionselement beim Einschieben in die Vorrichtung führt.

Vorteilhafterweise umfasst das Funktionselement eine Verbindungseinrichtung, wobei die Verbindungseinrichtung die Bauteile des Funktionselements verbindet, wobei die Bauteile das Funktionselement bilden.

Vorzugsweise ist das Funktionselement mehrstückig ausgebildet, sodass ein Bauteil des Funktionselements von einem anderen Bauteil des Funktionselements trennbar ist. Bevorzugterweise sind die Bauteile des Funktionselements miteinander durch eine Verbindungseinrichtung, z.B. Schrauben, verbunden. Die Verbindungseinrichtung ist vorteilhafterweise an der Rückseite des Funktionselements angeordnet. Dabei ist erst durch das Rausziehen des Funktionselements aus der Vorrichtung die Verbindungseinrichtung zugänglich. Dies erhöht vorteilhafterweise die Ästhetik der Funktionselemente, da die Verbindungseinrichtung im montierten Zustand nicht sichtbar ist.

Die Erfindung erstreckt sich auf eine Kombination aus einem System, umfassend ein Funktionselement und eine Vorrichtung, welche gemäß einer der oben beschriebenen Varianten ausgebildet sind, und einer Oberfläche an welcher die Vorrichtung mit Hilfe der Befestigungsmittel anbringbar ist.

### Figurenbeschreibung

Weitere Merkmale und Vorteile der Erfindung sind anhand eines schematisiert dargestellten Ausführungsbeispiels der vorliegenden Erfindung näher erläutert.

Im Einzelnen zeigt:
Fig. 1 eine Vorderansicht einer erfindungsgemäßen Vorrichtung zur Montage eines Funktionselements,
Fig. 2 eine perspektivische Ansicht von schräg hinten der erfindungsgemäßen Vorrichtung,
Fig. 3 eine Rückansicht der erfindungsgemäßen Vorrichtung,
Fig. 4 eine perspektivische Ansicht einer alternativen erfindungsgemäßen Vorrichtung mit Funktionselement,
Fig. 5 eine perspektivische Ansicht, wobei das Funktionselement in die Vorrichtung, nach Fig. 4, teilweise eingeschoben ist,
Fig. 6 eine perspektivische Ansicht der Vorrichtung im montierten ganz eingeschobenen Zustand mit dem Funktionselement.

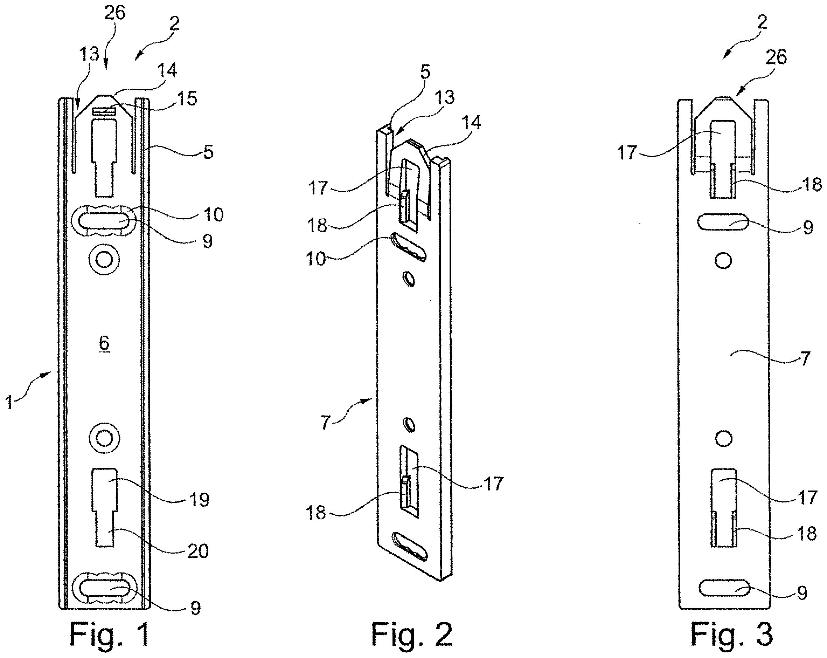

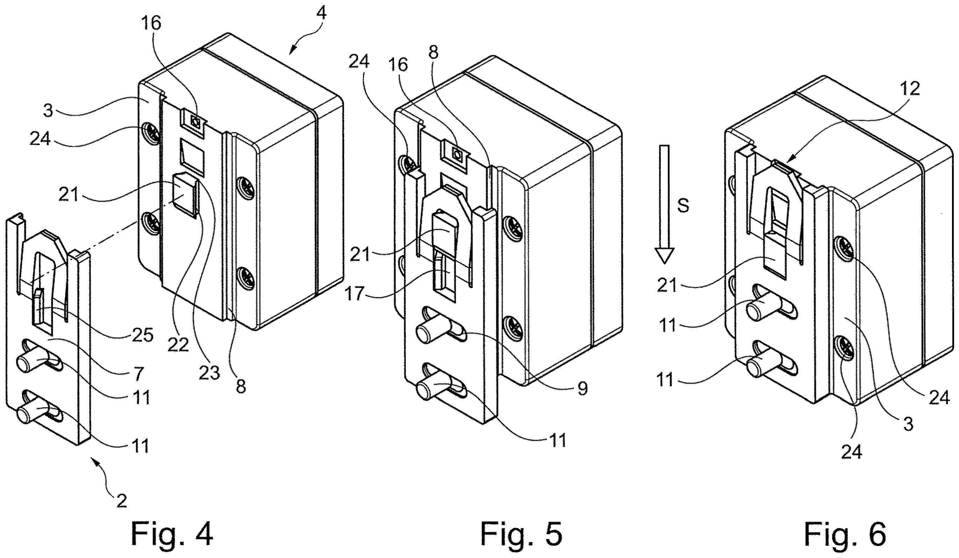

Die Vorderseite 1 der Vorrichtung 2 ist vorzugsweise mit einer Rückseite 3 eines Funktionselements 4, z.B. ein Gehäuse, verbindbar (s. Fig. 6). Die Vorrichtung 2 ist plattenartig ausgebildet, wobei an der Vorderseite 1 der Vorrichtung 2 Seitenränder 5 dicker ausgebildet sind als eine Fläche 6 der Vorderseite 1 (s. Fig. 1). Das Funktionselement 4 weist an der Rückseite 3 eine längliche Erhebung 8 auf, an welche die Seitenränder 5 an der Vorderseite 1 der Vorrichtung 2 anliegend angeordnet werden kann (s. Fig. 5).

Die Vorrichtung 2 weist weiterhin bevorzugterweise Materialausnehmungen in Form von Langlöcher 9 auf, damit die Vorrichtung 2 an eine Oberfläche (nicht dargestellt) mit Befestigungsmitteln 11, z.B. Schrauben, befestigt werden kann (s. Fig. 1). Die Oberfläche kann eine vertikale Ebene, z.B. eine Wand, und/oder eine geneigte Ebene und/oder eine horizontale Ebene, z.B. einen Tisch umfassen, die aus unterschiedlichen Material bestehen können.

Das Langloch 9 der Vorrichtung 2 weist vorteilhafterweise eine trichterartige bzw. keilartige Vertiefung 10 auf, so dass das Langloch 9 an der Vorderseite 1 größer ausgebildet ist als auf der Rückseite 7 (s. Fig. 1 und 3). Damit stehen vorteilhafterweise die Befestigungsmittel 11 im montierten Zustand der Vorrichtung 2 an der äußeren Fläche der Vorderseite 1 der Vorrichtung 2 nicht über. Bevorzugterweise kann damit die Oberfläche der Vorderseite 1 der Vorrichtung mit der Oberfläche der Rückseite 3 des Funktionselements 4 beim Ineinanderschieben in Kontakt kommen (s. Fig. 5, 6).

Die Langlöcher 9 sind auf der Vorderseite 1 vorzugsweise so ausgebildet, dass die Befestigungsmittel 11 in drei Positionen eingesetzt werden können. Dafür weisen die Langlöcher 9 wellenartige Vertiefungen 10 auf, wobei in jeden Bogenabschnitt das Befestigungsmittel 11 eingesetzt werden kann.

Es ist von Vorteil, wenn an der Vorrichtung 2 zumindest ein Langloch, vorzugsweise zwei Langlöcher 9 ausgebildet sind. Somit kann die Vorrichtung 2 vorteilhafterweise im montierten Zustand positionierbar an der Oberfläche befestigt werden. Weiter ist es bevorzugt möglich, wenn die Vorrichtung 2 zwei Langlöcher 9 aufweist, die Vorrichtung 2 vertikal und/oder horizontal und/oder quer zur Horizontalen oder Vertikalen an der Oberfläche beim Befestigen verschieben und in einer gewünschten Position befestigen zu können.

Eine Schnappsicherung 12 umfasst vorzugsweise eine Lasche 26, eine Erhebung 15 an der Lasche 26 und eine Gegenkontur 16 am Funktionselement 4, wobei an der Vorrichtung 2 die Lasche 26 mit Erhebung 15 ausgebildet ist. Die Lasche 26 ist bevorzugterweise relativ zum verbleibenden Teil der Vorrichtung 2 beweglich. Dafür ist vorteilhafterweise ein länglicher Einschnitt 13 an der Vorrichtung 2 vorhanden, wobei der längliche Einschnitt 13 zwischen den Seitenrändern 5, die eine stegartige Form haben, und Außenrändern 14 der Lasche 26 vorzugsweise beidseitig ausgebildet.

An der Lasche 26 ist vorzugsweise eine Rastnase angeordnet, welche mit dem Funktionselement 4 verrasten kann. Die Erhebung 15 ist z.B. in Form einer Rastnase vorzugsweise als ein Prisma ausgebildet. Eine abstehende Fläche der Erhebung bzw. des Prismas verrastet im ineinandergeschobenen Zustand vorteilhafterweise mit einer Gegenkontur 16 am Funktionselement 4 (s. Fig. 6).

Die Gegenkontur 16 am Funktionselement 4 ist vorzugsweise eine quaderförmige und/oder prismenförmige Vertiefung (s. Fig. 4). Beim Einrasten der Lasche 26 an der Gegenkontur 16 entsteht ein Klick-Geräusch, womit der Benutzer den Endmontagezustand bemerkt.

Die Vorrichtung 2 umfasst eine Führungsöffnung 17, die vorteilhafterweise rechteckig ausgebildet ist (s. Fig. 3). Abhängig von der Größe des Funktionselements 4 kann die Vorrichtung 2 ein, zwei oder mehrere Führungsöffnungen 17 aufweisen. Die Führungsöffnungen 17 werden bevorzugterweise durch Führungsstege 18 verschmälert, die in einer Führungsöffnung 17 der Vorrichtung 2 angeordnet sind (s. Fig. 2). Damit ist z.B. die Führungsöffnung 17 rechteckig an der Rückseite 7 der Vorrichtung 2 ausgebildet (s. Fig. 2). Auf der Vorderseite 1 der Vorrichtung 2 weist die Führungsöffnung 17 einen breiteren Bereich 19 und einen schmäleren Bereich 20 auf (s. Fig. 1). Die Führungsstege 18 sind an der Führungsöffnung 17 vorzugsweise gegenüberliegend und parallel angeordnet.

Das Funktionselement 4 umfasst vorzugsweise ein Führungselement 21, welches abstehend an der Rückseite 3 des Funktionselements 4 ausgebildet ist (s. Fig. 4). Das Führungselement 21 ist vorzugsweise trapezartig ausgebildet. Die Seiten des Führungselements 21 weisen bevorzugterweise zwei Abschnitte auf, einen Führungsvorsprung 22, der den Führungssteg 18 hintergreift und ein Abschnitt 23, der zwischen dem Führungsvorsprung 22 und der Rückseite 3 des Funktionselements 4 angeordnet ist.

Am Funktionselement 4 kann weiterhin eine Verbindungseinrichtung 24 angeordnet sein, die die Bauteile des Funktionselements 4 verbindet, wenn das Funktionselement 4 aus mehreren Bauteilen gebildet ist. Die Verbindungseinrichtung 24 ist vorteilhafterweise an der Rückseite 3 des Funktionselements 4 angeordnet, wobei die Verbindungseinrichtung 24 vorzugsweise Schrauben umfasst (s. Fig. 4-6).

Die Vorrichtung 2 ist vorzugsweise an einer Oberfläche, z.B. einer Wand, montiert. Zum Fixieren des Funktionselements 4 an der Vorrichtung 2, wird vorteilhafterweise das Führungselement 21 des Funktionselements 4 in den breiten Bereich 19 der Führungsöffnung 17 an der Vorrichtung 2 eingesetzt (s. Fig. 5). Das Funktionselement 4 wird bevorzugterweise in Schieberichtung S bewegt. Dabei gelangt vorteilhafterweise das Führungselement 21 in den schmalen Bereich 20 der Führungsöffnung 17 (s. Fig. 6). Beim Schiebevorgang hintergreift vorzugsweise der Führungsvorsprung 22 des Funktionselements 4 die Führungsstege 18 der Vorrichtung 2. Der Führungsvorsprung 22 am Funktionselement 4 wird bevorzugterweise entlang eines Führungsabschnitts 25 an den Führungsstegen 18 geführt. Weiter sind vorteilhafterweise die Seitenränder 5 an der Vorrichtung 2 so ausgebildet, dass die Seitenränder 5 entlang der länglichen Erhebung 8 am Funktionselement 4 beim Schiebevorgang geleitet werden können. Beim Schieben des Funktionselements 4 entlang der Schieberichtung S gelangt vorzugsweise die Erhebung 15 an der Lasche 26 in die Gegenkontur 16 am Funktionselement 4 (s. Fig. 6). Damit sind vorteilhafterweise die ineinandergeschobenen Systembauteile, welche das Funktionselement 4 und die Vorrichtung 2 umfassen, mechanisch fest miteinander fixiert. Die Erhebung 15 kann bevorzugterweise aus der Gegenkontur 16 am Funktionselement 4 mit Hilfe eines Werkzeuges, z.B. durch einen Schraubendreher, entfernt z.B. herausgeschoben werden. Damit kann das Funktionselement 4 von der Vorrichtung 2 demontiert werden.

### Bezugszeichenliste

- 1: Vorderseite
- 2: Vorrichtung
- 3: Rückseite
- 4: Funktionselement
- 5: Seitenränder
- 6: Fläche
- 7: Rückseite
- 8: Erhebung
- 9: Langlöcher
- 10: Vertiefung
- 11: Befestigungsmittel
- 12: Schnappsicherung
- 13: Einschnitt
- 14: Außenränder
- 15: Erhebung
- 16: Gegenkontur
- 17: Führungsöffnung
- 18: Führungssteg
- 19: Bereich
- 20: Bereich
- 21: Führungselement
- 22: Führungsvorsprung
- 23: Abschnitt
- 24: Verbindungseinrichtung
- 25: Führungsabschnitt
- 26: Lasche

## Patentansprüche

1. System aus einem Funktionselement (4), insbesondere Gehäuse, und einer Vorrichtung (2) zur Montage des Funktionselements (4), wobei die Vorrichtung (2) Mittel zur Befestigung (11) der Vorrichtung (2) an einer Oberfläche aufweist, wobei das Funktionselement (4) einen Innenraum zum Einsetzen von elektronischen und/oder elektrischen Bauteilen besitzt, wobei die Vorrichtung (2) und das Funktionselement (4) dazu ausgelegt sind, ineinandergeschoben zu werden, um eine mechanische Fixierung des Funktionselements (4) an der Vorrichtung (2), bei an einer Oberfläche montierter Vorrichtung (2), zu erhalten und dass eine Schnappsicherung (12) vorgesehen ist, um ein Auseinanderschieben der ineinandergeschobenen Systembauteile (2, 4) zu blockieren, wobei die Schnappsicherung (12) beim ineinandergeschobenen und fixierten Zustand der Vorrichtung (2) mit dem Funktionselement (4) von außen, bei an einer Oberfläche montierten Vorrichtung (2), zugänglich ist und lösbar ist, wobei die Schnappsicherung (12) eine mehrfache Montage und Demontage des Funktionselements (4) an bzw. von der Vorrichtung (2) erlaubt und/oder unterstützt, **dadurch gekennzeichnet, dass** die Vorrichtung (2) plattenartig ausgebildet ist, wobei an einer Vorderseite (1) der Vorrichtung (2) Seitenränder (5) dicker ausgebildet sind als eine Fläche (6) der Vorderseite (1) und dass das Funktionselement (4) an einer Rückseite (3), die mit der Vorderseite (1) der Vorrichtung (2)verbindbar ist, eine längliche Erhebung (8) aufweist, an welcher die Seitenränder (5) an der Vorderseite (1) der Vorrichtung (2) im verbundenen Zustand anliegen, dass die Vorrichtung (2) eine Führungsöffnung (17) mit Führungsabschnitten (25) für ein zu den Führungsabschnitten (25) passendes Führungselement (21) am Funktionselement (4) umfasst, wobei auf der Vorderseite (1) der Vorrichtung (2) die Führungsöffnung (17) einen breiteren Bereich (19) und einen schmaleren Bereich (20) aufweist und dass das Funktionselement (4) das Führungselement (21) umfasst, welches abstehend an der Rückseite (3) am Funktionselement (4) auf der Erhebung (8) ausgebildet ist.

2. System nach einem der vorhergehenden Ansprüche, **dadurch gekennzeichnet, dass** die Vorrichtung (2) eine Lasche (26) umfasst, welche beweglich, vorzugsweise elastisch beweglich z.B. federnd, an dem verbleibenden Teil der Vorrichtung (2) angeordnet ist.

3. System nach einem der vorhergehenden Ansprüche, **dadurch gekennzeichnet, dass** die Lasche (26) eine Erhebung (15) umfasst, welche so ausgebildet ist, dass die Erhebung (15) mit einer auf die Erhebung (15) angepasste Gegenkontur (16) am Funktionselement (4) im Endmontagezustand verrastbar ist.

4. System nach einem der vorhergehenden Ansprüche, **dadurch gekennzeichnet, dass** das Funktionselement (4) eine Gegenkontur (16) umfasst, die auf die Erhebung (15) an der Vorrichtung (2) angepasst ist.

5. System nach einem der vorhergehenden Ansprüchen, **dadurch gekennzeichnet, dass** die Vorrichtung (2) eine Materialausnehmung (9) aufweist, um Befestigungsmittel (11) aufzunehmen.

6. System nach einem der vorhergehenden Ansprüche, **dadurch gekennzeichnet, dass** die Vorrichtung (2) eine Führungsöffnung (17) umfasst, welche einen breiten Bereich (19) und einen schmalen Bereich (20) aufweist, wobei im schmalen Bereich (20) parallel ausgerichtete Führungsstege (18) vorhanden sind.

7. System nach einem der vorhergehenden Ansprüche, **dadurch gekennzeichnet, dass** die Führungsöffnung (17) dazu ausgebildet ist, das Führungselement (21) des Funktionselements (4) aufzunehmen.

8. System nach einem der vorhergehenden Ansprüche, **dadurch gekennzeichnet, dass** das Führungselement (21) von einer Rückseite (3) des Funktionselements (4) abstehend ausgebildet ist, wobei die Rückseite (3) des Funktionselements (4) beim Ineinanderschieben der Vorrichtung (2) zugewandt ist.

9. System nach einem der vorhergehenden Ansprüche, **dadurch gekennzeichnet, dass** das Funktionselement (4) eine Verbindungseinrichtung (24) umfasst, wobei die Verbindungseinrichtung (24) die Bauteile des Funktionselements (4) verbindet, wobei die Bauteile das Funktionselement (4) bilden.

10. Kombination aus einem System (2, 4) nach einem der vorhergehenden Ansprüche und einer Oberfläche an welcher die Vorrichtung (2) mit Hilfe der Befestigungsmittel (11) anbringbar ist.

## Claims

1. System consisting of a functional element (4), in particular a housing, and of a device (2) for mounting the functional element (4), wherein the device (2) has means for fastening (11) the device (2) to a surface, wherein the functional element (4) has an interior space for the insertion of electronic and/or electrical components, wherein the device (2) and the functional element (4) are designed to be pushed together in order to mechanically fasten the functional element (4) to the device (2) when the device (2) has been mounted on a surface, and in that a snap-action securing means (12) is provided in order to prevent the pushed-together system components (2, 4) from being pushed apart, wherein the snap-action securing means (12) is accessible and releasable from the outside when the device (2) is in the pushed-together and fastened state with the functional element (4) and when the device (2) has been mounted on a surface, wherein the snap-action securing means (12) permits and/or assists repeated mounting and removal of the functional element (4) on and from the device (2), **characterized in that** the device (2) is of plate-like design, wherein, on a front side (1) of the device (2), lateral edges (5) are designed to be thicker than a surface (6) of the front side (1), and **in that** the functional element (4) has, on a rear side (3) that can be connected to the front side (1) of the device (2), an elongate elevation (8), against which the lateral edges (5) on the front side (1) of the device (2) abut in the connected state, **in that** the device (2) comprises, on the functional element (4), a guide aperture (17) with guide portions (25) for a guide element (21) that matches the guide portions (25), wherein, on the front side (1) of the device (2), the guide aperture (17) has a wider region (19) and a narrower region (20), and **in that** the functional element (4) comprises the guide element (21), which is formed on the elevation (8) so as to protrude on the rear side (3) on the functional element (4).

2. System according to one of the preceding claims, **characterized in that** the device (2) comprises a tab (26), which is arranged in a movable manner, preferably in an elastically movable manner, for example resiliently, on the remaining part of the device (2).

3. System according to either of the preceding claims, **characterized in that** the tab (26) comprises an elevation (15), which is designed such that the elevation (15) can be interlocked with a mating contour (16), which is adapted to the elevation (15), on the functional element (4) in the final mounted state.

4. System according to one of the preceding claims, **characterized in that** the functional element (4) comprises a mating contour (16), which is adapted to the elevation (15) on the device (2).

5. System according to one of the preceding claims, **characterized in that** the device (2) has a material recess (9) in order to accommodate fastening means (11).

6. System according to one of the preceding claims, **characterized in that** the device (2) comprises a guide aperture (17), which has a wide region (19) and a narrow region (20), wherein parallel-oriented guide webs (18) are present in the narrow region (20).

7. System according to one of the preceding claims, **characterized in that** the guide aperture (17) is designed to accommodate the guide element (21) of the functional element (4).

8. System according to one of the preceding claims, **characterized in that** the guide element (21) is formed so as to protrude from a rear side (3) of the functional element (4), wherein the rear side (3) of the functional element (4) faces towards the device (2) during the pushing-together operation.

9. System according to one of the preceding claims, **characterized in that** the functional element (4) comprises a connecting device (24), wherein the connecting device (24) connects the components of the functional element (4), wherein the components form the functional element (4).

10. Combination consisting of a system (2, 4) according to one of the preceding claims and of a surface to which the device (2) can be attached with the aid of the fastening means (11).

## Revendications

1. Système composé d'un élément fonctionnel (4), notamment d'un boîtier, et d'un dispositif (2) pour le montage de l'élément fonctionnel (4), le dispositif (2) présentant des moyens de fixation (11) du dispositif (2) sur une surface, l'élément fonctionnel (4) possédant un espace intérieur pour l'insertion de composants électroniques et/ou électriques, le dispositif (2) et l'élément fonctionnel (4) étant conçus pour être emboîtés l'un dans l'autre afin d'obtenir une fixation mécanique de l'élément fonctionnel (4) sur le dispositif (2), lorsque le dispositif (2) est monté sur une surface, et une sécurité à déclic (12) étant prévue pour bloquer un déboîtement des composants de système (2, 4) emboîtés, la sécurité à déclic (12) étant accessible et amovible de l'extérieur à l'état emboîté et fixé du dispositif (2) avec l'élément fonctionnel (4), lorsque le dispositif (2) est monté sur une surface, la sécurité à déclic (12) permettant et/ou supportant un montage et un démontage multiples de l'élément fonctionnel (4) sur ou à partir du dispositif (2), **caractérisé en ce que** le dispositif (2) est configuré en forme de plaque, des bords latéraux (5) étant configurés plus épais sur un côté avant (1) du dispositif (2) qu'une surface (6) du côté avant (1), et **en ce que** l'élément fonctionnel (4) présente sur un côté arrière (3), qui peut être relié au côté avant (1) du dispositif (2), un relief allongé (8) sur lequel les bords latéraux (5) s'appuient sur le côté avant (1) du dispositif (2) à l'état relié, **en ce que** le dispositif (2) comprend une ouverture de guidage (17) avec des sections de guidage (25) pour un élément de guidage (21) adapté aux sections de guidage (25) sur l'élément fonctionnel (4), l'ouverture de guidage (17) présentant sur le côté avant (1) du dispositif (2) une zone plus large (19) et une zone plus étroite (20), et **en ce que** l'élément fonctionnel (4) comprend l'élément de guidage (21) qui est formé en saillie sur le côté arrière (3) sur l'élément fonctionnel (4) sur le relief (8).

2. Système selon l'une quelconque des revendications précédentes, **caractérisé en ce que** le dispositif (2) comprend une patte (26) qui est agencée de manière mobile, de préférence de manière mobile élastiquement, par exemple à ressort, sur la partie restante du dispositif (2).

3. Système selon l'une quelconque des revendications précédentes, **caractérisé en ce que** la patte (26) comprend un relief (15) qui est configuré de telle sorte que le relief (15) peut être enclenché avec un contre-contour (16) adapté au relief (15) sur l'élément fonctionnel (4) à l'état de montage final.

4. Système selon l'une quelconque des revendications précédentes, **caractérisé en ce que** l'élément fonctionnel (4) comprend un contre-contour (16) adapté au relief (15) sur le dispositif (2).

5. Système selon l'une quelconque des revendications précédentes, **caractérisé en ce que** le dispositif (2) présente un évidement de matière (9) pour recevoir des moyens de fixation (11).

6. Système selon l'une quelconque des revendications précédentes, **caractérisé en ce que** le dispositif (2) comprend une ouverture de guidage (17) qui présente une zone large (19) et une zone étroite (20), des nervures de guidage (18) orientées parallèlement étant présentes dans la zone étroite (20) .

7. Système selon l'une quelconque des revendications précédentes, **caractérisé en ce que** l'ouverture de guidage (17) est configurée pour recevoir l'élément de guidage (21) de l'élément fonctionnel (4).

8. Système selon l'une quelconque des revendications précédentes, **caractérisé en ce que** l'élément de guidage (21) est configuré en saillie par rapport à un côté arrière (3) de l'élément fonctionnel (4), le côté arrière (3) de l'élément fonctionnel (4) étant tourné vers le dispositif (2) lors de l'emboîtement.

9. Système selon l'une quelconque des revendications précédentes, **caractérisé en ce que** l'élément fonctionnel (4) comprend un appareil de liaison (24), l'appareil de liaison (24) reliant les composants de l'élément fonctionnel (4), les composants formant l'élément fonctionnel (4).

10. Combinaison d'un système (2, 4) selon l'une quelconque des revendications précédentes et d'une surface sur laquelle le dispositif (2) peut être disposé à l'aide des moyens de fixation (11).
